# EUROPEAN PATENT SPECIFICATION

(11) **EP 2 378 037 B1**
(45) Date of publication and mention of the grant of the patent: **28.01.2015**
(21) Application number: 10160095.5
(22) Date of filing: 15.04.2010
(51) Int. Cl.: E02D 27/42, F21V 33/00, G08G 1/095, H01L 31/04, F21W 131/10, F21Y 101/02, E04H 17/20, E04H 17/16

(54) **Illuminated double-profile fence post and associated fence structure**
Beleuchteter Doppelprofilzaunpfosten und zugehörige Zaunstruktur
Piquet de clôture à double profil éclairé et structure de clôture associée

(43) Date of publication of application: 19.10.2011
(73) Proprietor: Kösedag Tel Örme Sanayi Ve Ticaret Ithalat Ihracat A.S., 34940 Istanbul (TR)
(72) Inventor: Kösedag, Ali, 34940, Istanbul (TR)
(74) Representative: Sevinç, Erkan

(56) References cited:
- EP-A1- 1 098 051
- EP-A1- 1 306 502
- EP-A1- 2 039 853
- EP-A1- 2 088 262
- EP-A1- 2 116 676
- DE-U1- 20 102 332
- FR-A1- 2 888 271
- US-A1- 2006 092 646
- US-A1- 2008 149 786

## Description

### Technical Field of the Invention

The present invention relates to a fence post adapted to be erected generally in an equally spaced manner around an area, e.g. a residential area. In particular, the present invention relates to a fence post which eliminates use of fastening means for fixing a mesh wire or a framed panel to said posts and to a fence which comprises said posts.

### Background of the Invention

A plurality of patents/patent applications are present in the field in relation to fence posts and to their configuration with regards to fixing of posts and/or fences and fittings thereof. In general terms, a design priority taken into account in the field is to obtain a fence post which requires a reduced number of fastening means or mounting fittings without compromising safety characteristics. A post system requiring a reduced number of fittings and fastening means such as bolts, nuts, clips, and clamps is advantageous as it involves simplicity and necessitates less man-hour work during installation. A system consisting of a limited number of components is also advantageous in that it requires maintenance to a lesser extent. Further use of such fittings generally damage dyed surfaces or coatings on the fence material and result in corrosion of the material.

Document GB 2035409 A discloses a fence post according to the preamble of claim 1.

The present invention, involves a reduced number of components so as to provide a fence post system which is quickly and easily mountable on site and which is self-supporting in terms of mechanical stability as different components attached to form up the system are arranged in an inseparable manner when mounted. The self-supporting structure is crucial in that simpler constructions are available without requiring additional fitting elements or fastening means. Further, a secure structure in mechanical terms without fittings may only be achieved with a design in which different components are attached to each other in such a manner that every single component is secured relative to an adjoining component. This is achieved by the special design according to the present invention, which allows interlocking of adjoining components without additional fixing means and without compromising overall simplicity and/or safety of the system. The present invention provides a system in which different system parts fit or slide one within another so as to enable a simple and robust connection in contrary to prior art systems.

Conventional fences require use of fastening means such as bolts and nuts, rivets, welding, clamps, screws, shackles etc. in order to attach the fence material to fence posts. The fastening means not only bring an add-on the costs of the end product but also require additional labor time for cutting, fixing, screwing or welding. In order to eliminate surface corrosion, they shall either be made of a costly non-corrosive material or painted or coated with a corrosion inhibitor upon installation.

The present invention provides further the effect that the bending moment of the erected fence post is increased by way of providing a post such that it is erected with a configuration in which it is substantially less vulnerable to hits by intruders.

### Objects of the Invention

One of the objects of the present invention is to provide a fence post system which eliminates use of fastening means or mounting fittings in order to affix a wired mesh or a framed panel to fence posts.

Another object of the present invention is to provide a fence post in which the bending moment of the erected fence post is increased such that it is substantially less vulnerable to hits by intruders.

Another object of the present invention is to provide a quickly and easily mountable fence post system which reduces labor costs during installation.

Another object of the present invention is to provide a self-supporting fence post in terms of mechanical stability, in particular bending moment of the post profile

A further object of the present invention is to provide a system in which different system parts fit or slide one within another so as to enable a simple and robust connection.

Still a further object of the invention is to provide a post system for fences which allows cornering without modification of the posts.

Yet another object of the invention is to provide a post system for fences, said posts being obtained by extrusion of metal whereby fabrication costs as well as raw material costs are reduced.

### Summary of the Invention

The present invention provides a two-part tubular post body having ear portions extending so as to define and delimit a longitudinal space suitable for receiving an end part of a fence portion in an interlocking manner. Two parts of the tubular hollow bodies are designed to engage into each other. Ear portions are provided at both sides of the post profile. Outer surfaces of each ear portion comprise lateral openings for receiving a fence wire portion. Said openings are longitudinally arranged, generally, in an equally spaced manner, which is suitable for engagement of fence material. Typically, the fence material may be selected from one or more of the group consisting of mesh wires, welded wires, razor wires, gabion, single panels, double reinforced panels and framed panels.

According to the present invention, the tubular post comprises a first part that have ear portions on the left and right of an outwardly protruding portion where said ear portions have at their outer ends inwardly extending lips. The post comprises a second part which is a cylindrical hollow body disposed within said first part. The first part has a plurality of lateral openings adapted to receive horizontal ends of a fence material, in particular a mesh wire or a framed panel, throughout its length.

The first part of the post features a first closed-geometry longitudinally hollow inner profile interconnected by at least two longitudinally extending bridging elements to a second closed-geometry longitudinally extending outer profile. The bridging elements among said profiles are arranged preferably in a symmetrical manner. The longest distance in between two circumferential points on a horizontal plane of the post is perpendicular to the fence line.

The tubular post comprises one or more longitudinal housing (s) for receiving illuminating elements (25).

### Brief Description of the Figures

Accompanying drawings are given solely for the purpose of exemplifying a fence post and fence mounted using said post, whose advantages over prior art were outlined above;

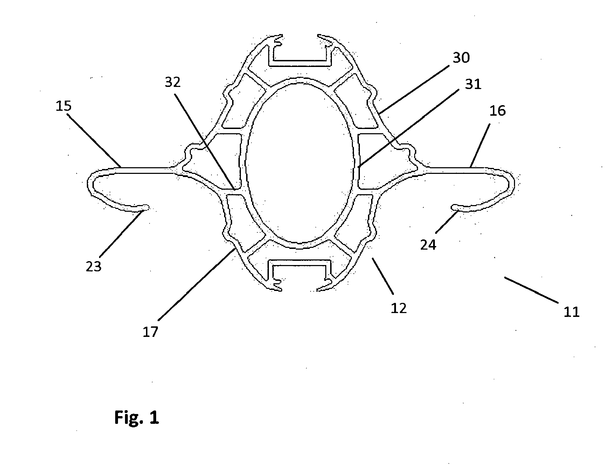

Fig. 1 demonstrates a cross sectional view of the first part of the fence post according to the present invention.

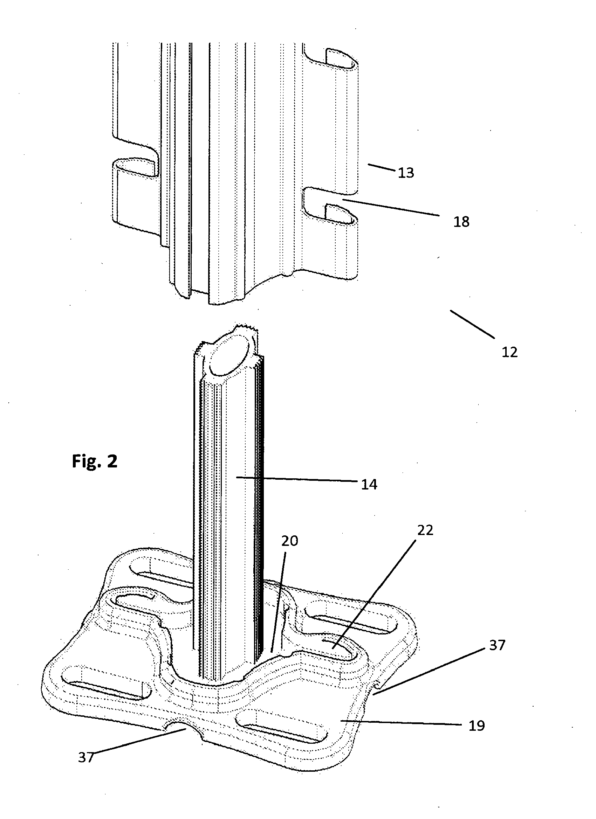

Fig. 2 demonstrates a perspective view of the first and the second parts of the fence post according to the present invention in disassembled position.

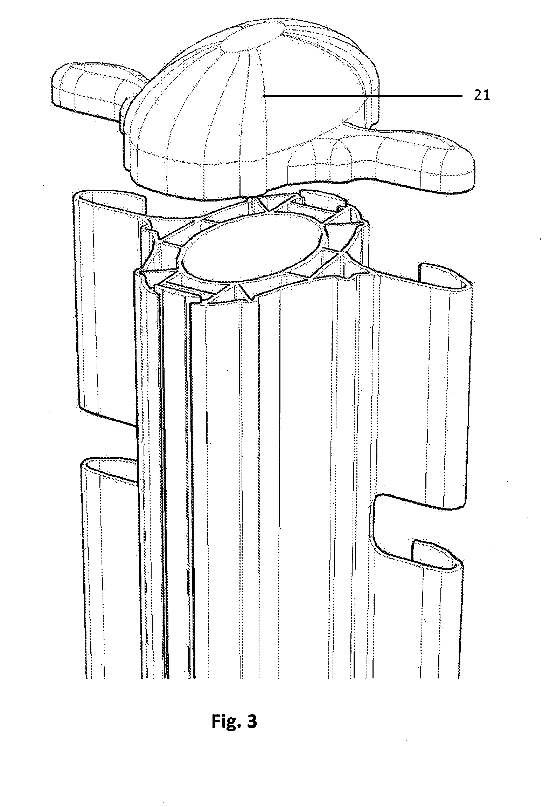

Fig. 3 demonstrates a perspective view of a fence post with the cap (not claimed).

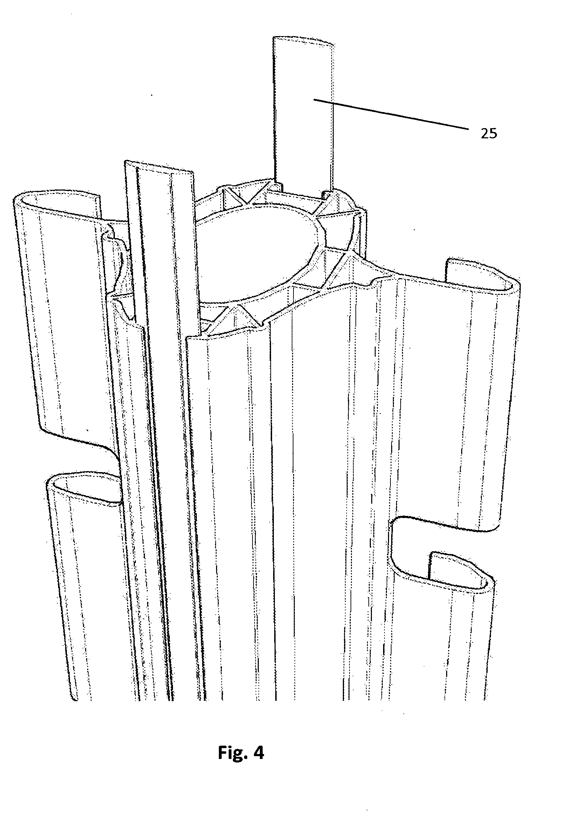

Fig. 4 demonstrates a perspective view of a fence post with illuminating elements (not claimed).
Fig. 5 demonstrates a perspective view of a fence post according to the invention with the fence being mounted.
Fig. 6 demonstrates a cross sectional view of a fence post with the illuminating elements according to the present invention.
Fig. 7 demonstrates a prior art panel fence having vertical portions and horizontal portions.
Fig. 8 demonstrates an upper view of the prior art panel fence of Fig. 7.
Fig. 9 demonstrates an side view of the prior art panel fence of Fig. 7.

### Detailed Description of the Invention

Referring now to the figures outlined above, the present invention provides a fence post system (11) having a fence post (12) comprising two post parts (13, 14) that fit into each other to form up a fence post (12). Assembled post parts (13, 14) extend longitudinally in a telescopic manner. Ear portions (15, 16) at both sides of said fence post (12) define and delimit radially enlarged lateral spaces, which also extend longitudinally along the entire length of said post (12).

Said first post part (13) is shaped to have a circular-like central portion (17) at both sides of which said ear portions (15, 16) extend outwardly. Said central portion (17) being circular-like in the preferred embodiment, it is not necessary to use this form and various other shapes in cross section (e.g. ellipse, triangle, square, pentagonal, hexagonal or other polygonal shapes) may be utilized for providing a fence post (12).

Outer surfaces of each ear (15, 16) comprise lateral openings (18) arranged vertically in spaces along the longitudinal length of the tubular post body (12). They might well be positioned in an equally spaced manner.

The fence modules used according to the preferred embodiment of the present invention, conventionally comprising intersecting bars, comprisevertical and horizontal fence portions fastened to the post (12) without use of additional fittings. Vertically extending outermost bars at both sides of each module is fitted in the spaces delimited by ear portions (15, 16) of said post body (12). An outermost vertical bar fitted in said space communicates with horizontal fence portions integral thereto through openings (18).

Post parts (13, 14) being fitted into each other, each part (13, 14) is now only allowed a vertical, i.e. telescopic movement. Prior to assembling post parts (13, 14), vertically extending outermost fence portions at both sides of a fence module are fitted in the spaces delimited by ear portions (15, 16) of said tubular post body (12).

The present invention provides the effect that the bending moment of the fence post (12) is increased by way of providing a post (12) such that it is erected with a configuration in which the longest distance in between two circumferential points on a horizontal plane of the post (12) is perpendicular to the fence line. Therefore the fence line is interrupted by the post (12) bodies such that the shortest distance in between two circumferential points on a horizontal plane of the post (12) coincides to the fence line.

The perpendicular arrangement of the posts with respect to the fence line is irrespective of any region where posts (12) are disposed with turning points because the longest distance, i.e. the longitudinal distance in between two circumferential points on a horizontal plane of the posts (12) in such locations are also disposed to be longitudinally perpendicular in cross-section to the fence line. As it is not possible by an intruder to overturn a post by lateral hits because two consecutive posts (12) are laterally supported by the tightened fence in between, the posts (12) are more vulnerable to hits in longitudinal axes of a horizontal post (12) plane.

The post (12) of the present invention is provided such that it features a double profile post (12) in which an outer profile (30) is connected to an inner profile (31) by means of a plurality of preferably symmetrically arranged bridges (32). To this end, said first part (13) of the post (12) features a first closed geometry longitudinally hollow fence (12) profile (31) interconnected by bridging elements (32) to a second closed geometry longitudinally extending fence (12) profile (30) enclosed said first profile (31). Said first part (13) of the fence post (12) comprised of said two interconnected profiles (30, 31) is fitted onto said second post (12) part (14) in a telescopic manner.

A fence post (12) comprised of a double-profile first part (13) fitted onto a second part (14) substantially increases mechanical stability and bending moment of the post (12) system against intruders. In addition, the perpendicular arrangement of the posts (12) with respect to the fence line further enhances resistance to hits by intruders with an effort to overturn a post (12) as explained above.

The post (12) is produced from extruded metal, preferably aluminum and provides a more efficient production process in terms of economical and functional benefits. Aluminum is particularly useful for production of the post material since it is a soft metal and can easily be extruded. However, other metals may also be used for the production of the tubular post of the present invention.

According to the present invention, the fence post (12) in interlocking communication with fence modules is seated on a base (19) having a corresponding cavity (20) for vertically receiving said post (12). The cavity (20) of the base (19) is particularly shaped and dimensioned to receive the base of the post (12) so as to support and keep the same integral. Likewise, a cap (21) whose internal cavity is shaped and dimensioned to receive the top of said post (12) also serves to the same purpose of supporting and keeping the post integral in erected form. More preferably, said base (19) has a plurality of mounting slots (22) in the shape that allow limited transitional movement of the post (12). This feature is especially advantageous during on-site installation and particularly stretching of fence material.

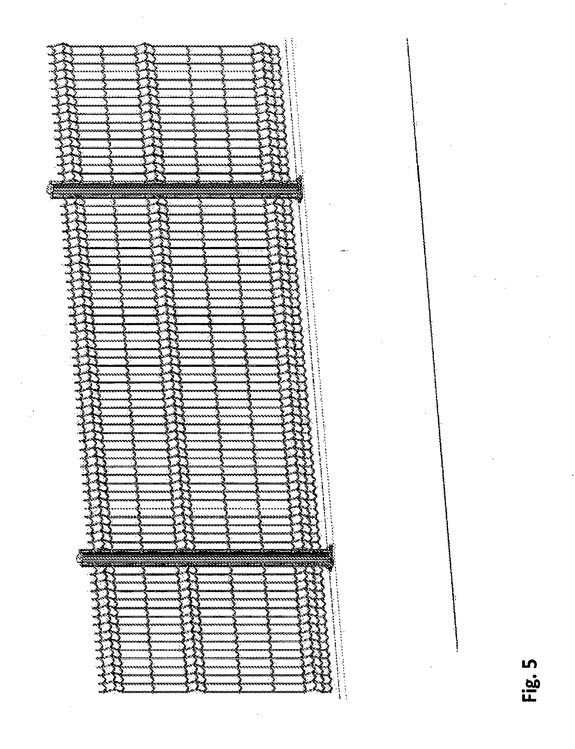

A fence post (12) obtained by way of fitting of components into each other in a reliable manner without use of additional fittings also enables use of thinner material in manufacturing, thereby allowing material saving. Fig. 5 demonstrates a fence panel with horizontal bars extending into the openings (18). The present arrangement of the post (12) allows different fence types and configurations to be assembled with the post (12). For instance, metal mats or a welded wire mesh may be configured to be assembled with the post (12) according to the present invention. This can for instance be achieved without modifying present openings (18) by way of an interlocking connection.

In the preferred embodiment, the first and second parts are produced by extruding metal, thereby having an integral structure without any securing means.. The present invention is advantageous in that it eliminates losses of conventional techniques that rely on classical methods like cutting, welding, clamping etc. Therefore, it is preferable to eliminate post-manufacture processes to avoid associated labor and raw material costs and opt for crimping, extruding or pressing.

Following insertion of vertically extending fence portions in the longitudinal spaces delimited by ear portions (15, 16) and alignment of adjoining horizontally extending fence portions integral thereto, a cap (21) is placed upon the post (12) so as to cover both the circular-like portion (17) and adjoining ear portions (15, 16). Presence of the cap (21) further ensures securing of essential components of the post (12), i.e. of post parts (13, 14) and vertical fence portions.

Openings (18) extending along all around inwardly extending lips (23, 24) of said ear portions (15, 16) at their outer ends provides spaces for transversal displacement of a fence portion in said opening (18). This is especially advantageous in that it avoids use of a specially adapted corner post(s). The arrangement of the present invention is suitable for providing a turning angle up to 120 degrees in corners without use of additional material or modifying the post structure.

The invention provides a tubular post (12) in which said first part (13) comprises one or more longitudinal openings (33) for receiving illuminating elements (25). Said illuminating elements may be powered through solar panels or by mains supply. Appropriate power supply and storage means are within the practice of the skilled craftsman. Said longitudinal housings (33) receiving said illuminating elements (25) are closed by longitudinal coverings (34) providing a dovetail connection with the open end of said housings (33). To this end, said coverings (34) has a first and a second end, each end fitting into said housings' (33) open end lateral lips (35) by sliding said coverings (34) inside said housings (33) before mounting said caps (21). Said coverings (34) provide the effect that said illuminating elements (25) are protected against environmental factors such as humidity and rainy weather conditions. Further, said coverings (34), when mounted, providing a flush communication with the remaining outer surface of the post (12) provides both a more aesthetical and a concealed or at least less noticeable configuration to a casual intruder. Said coverings (34) are made out of polycarbonate for maximum security. This is especially advantageous against intrusion attempts using a sharp object such as a screwdriver for damaging the illuminating elements (25).

The present invention therefore provides a post (12) for a fence comprising a hollow longitudinally extending first part (13) which comprises ear portions (15, 16) at both sides of a central portion (17), where said ear portions (15, 16) have at their outer ends inwardly extending lips (23, 24) with a plurality of longitudinally extending lateral openings (18) adapted to receive ends of a fence material and a second part (14) which extend longitudinally in said first part (13) in a telescopic manner. Said first part (13) of the post (12) features a first closed-geometry longitudinally hollow inner profile (31) interconnected by at least one longitudinally extending bridging element (32) to a second closed-geometry longitudinally extending outer profile (30) enclosed said first profile (31).

The ear portions extending so as to define and delimit a longitudinal space suitable for receiving an end part of a fence portion is particularly advantageous in that the post has a width much larger than conventional posts. Since the post has a wider profile, less fence material is required to cover a fixed distance. It should be noted that the ear portions on both sides of the post provides additional width that eliminates use of a wired fence in the amount of the width of the ear portions. Hence, the post according to the present invention allows cost reduction on site installation.

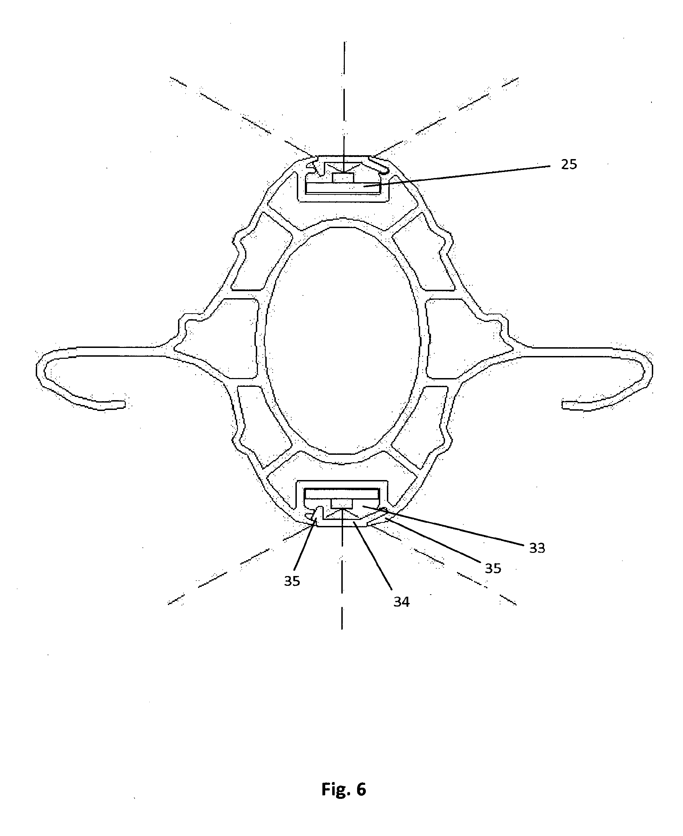

The base (19) has cavities (37) on its lateral surfaces for running power supply cables to the illuminating elements (25). These cavities (37) allow concealed passage of power cables such that the power supply cables can be prevented from cutting attempts from outside. As might be seen on Fig. 6, the illuminating elements (25) may be provided on both the front and the rear side of the fence post (12). There are one or more longitudinal housing(s) (33) for receiving illuminating elements (25) on the profile. It is preferable to supply power to a plurality of the fence posts in parallel setup since a cut or interruption in one of the posts would in that case would not prevent supply of power to the other posts. The illuminating means are preferably LEDs (light emitting diods) consuming relatively low energy compared to conventional lighting means. It is further possible to utilize color changing LEDs in a row of fence posts.

It is an option to produce the cap (21) of transparent material in order to obtain a better aesthetic of the fence posts. Since the light from the lighting elements (25) would refract from inside the cap to the outside, it would be possible to obtain a better visual indication on the fence posts.

An inter-related product configured to be used together with the post (12) according to the present invention is a framed panel fence (36) having integral vertical and horizontal portions to be mounted on said posts (12).

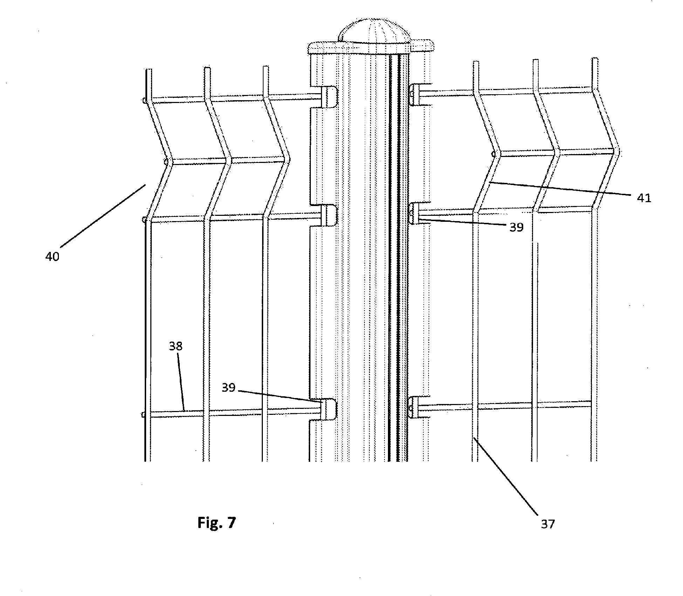

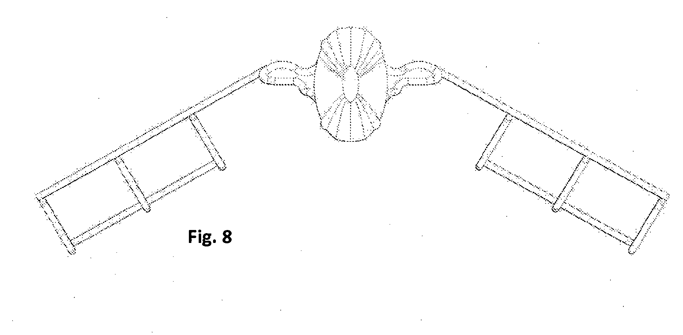

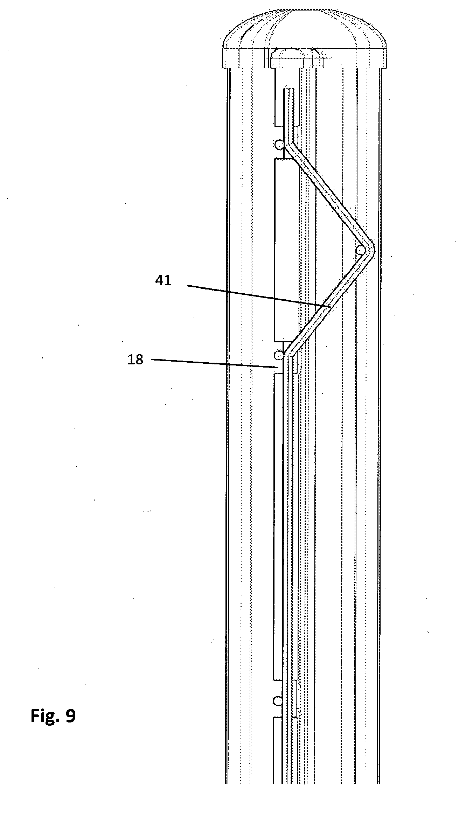

Fig. 7 demonstrates a prior art panel fence (36) having vertical (37) and horizontal portions (38). The framed fence (36) has an outermost vertical part (39) engaging within the longitudinal space defined by said ear portions (15, 16) of the post (12). The fence panel (36) has an upper part (40) with panel portions (41) inclined with respect to the vertical axis in lieu of vertical components. This upper part is aimed at providing both visual appearance diversity and an additional physical obstacle to a casual intruder who is climbing the fence (36). The outermost part (39) engaging within the longitudinal space defined by said ear portions (15, 16) in the upper part (40) of the fence panel (36) does not comprise said inclined panel portions (41) as these portions (41) are not appropriately shaped to engage with the lateral openings (18) as shown in Fig. 9. Further, these may also pose a restriction in turning angle in areas where consecutive posts are erected to provide a turning point. This is illustrated in Fig. 8 where said inclined portions (41) are removed to provide a turning arrangement with an unrestricted angle of turning.

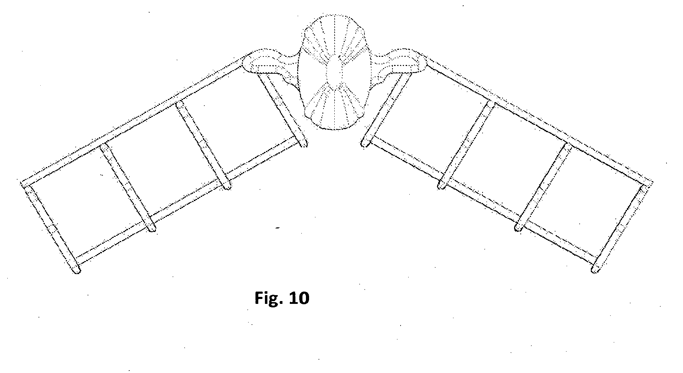

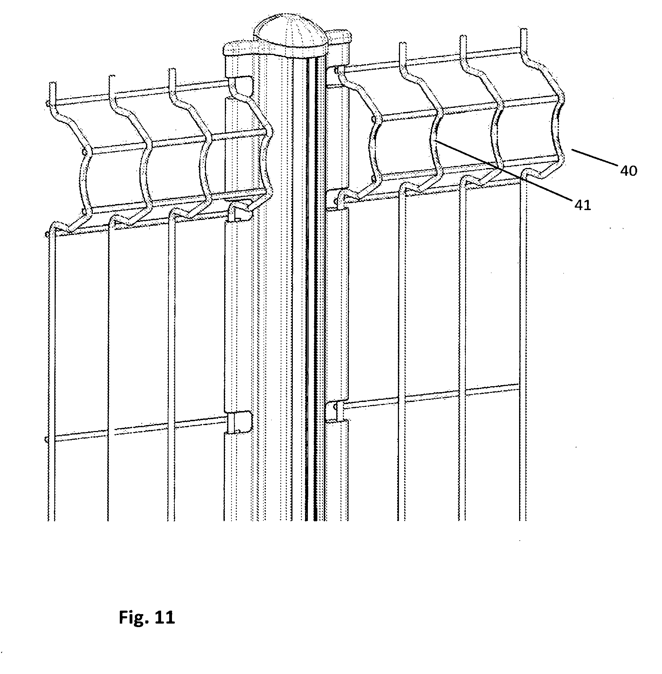

These disadvantages of the prior art fence (36) are eliminated with the panel fence (36) of the present invention. The fence (36) is configured to be used with the post (12) of the invention having longitudinally extending lateral ear portions (15, 16) defining a longitudinal inner space for receiving a framed panel (36) with an upper part (40) in which inclined panel portions (41) are also present in the outermost part (39) engaging within the longitudinal space defined by said ear portions (15, 16). To this end, the fence panel (36) of the invention as demonstrated in Fig. 10 to 12, comprise an upper part (40) with upper part (40) panel portions (41) as detailed below.

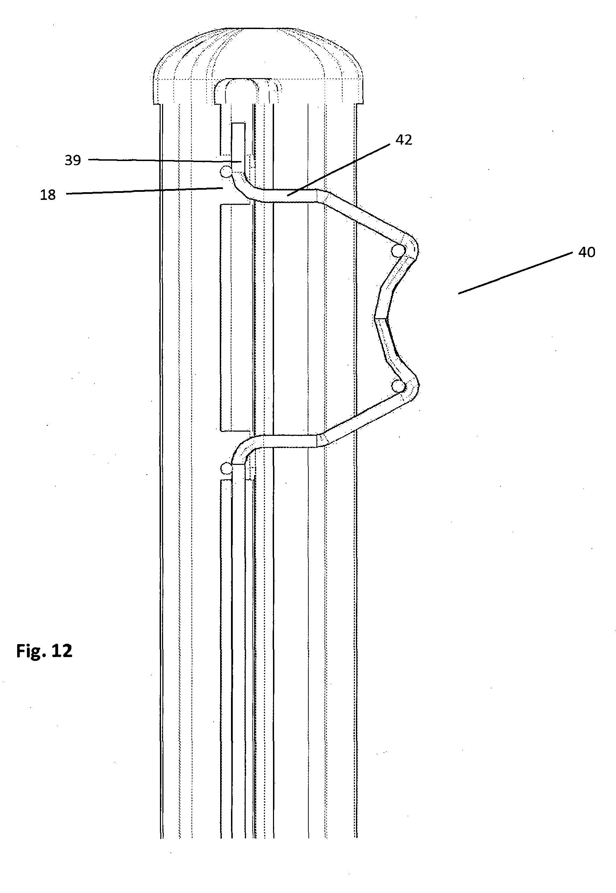

As seen in Fig. 12, the upper part (40) of the fence (36) panel has fence portions (42) in direct proximity of said lateral openings (18) extending perpendicular to the vertical fence portions (39) within the longitudinal space defined by said ear portions (15, 16). This arrangement provides the effect that said fence portions (42) in direct proximity of said lateral openings (18) is appropriately shaped to allow rotation of said fence portions (42) around the longitudinal axis defined by the space in said ear portions (15, 16) and in said openings (18) such that an improved angle of turning is achieved as seen in Fig. 10.

## Claims

1. A post (12) for a fence comprising a hollow longitudinally extending first part (13) which comprises ear portions (15, 16) at both sides of a central portion (17), a second part (14) which extend longitudinally in said first part (13) in a telescopic manner, said first part (13) of the post (12) comprises one or more longitudinal housing(s) (33) for receiving illuminating elements (25), said one or more longitudinal housing(s) (33) comprise(s) one or more illuminating element(s) (25), **characterized in that**;
said ear portions (15, 16) have at their outer ends inwardly extending lips (23, 24) with a plurality of longitudinally extending lateral openings (18) adapted to receive ends of a fence material, said first part (13) of the post (12) features a first closed-geometry longitudinally hollow inner profile (31) interconnected by at least two longitudinally extending bridging elements (32) to a second closed-geometry longitudinally extending outer profile (30) enclosing said first profile (31),
said longitudinal housing(s) (33) comprising one or more illuminating element(s) is/are closed by longitudinal covering(s) (34) having a first and a second end, each end fitting into said housing's/housings' (33) open end lateral lips (35) by sliding said covering(s) (34) inside said housing(s) (33) such that said longitudinal covering(s) (34) is/are configured to have a dovetail connection with the open end of said longitudinal housing(s) (33) and,
said longitudinal covering(s) (34) is/are flush with the remaining outer surface of the post (12).

2. A tubular post (12) for a fence as set forth in Claim 1 wherein said bridging elements (32) among said profiles (30, 31) are arranged in a symmetrical manner.

3. A tubular post (12) for a fence as set forth in Claim 2 wherein the longest distance in between two circumferential points on a horizontal plane of the post (12) is perpendicular to the fence line.

4. A tubular post (12) for a fence as set forth in Claim 1 wherein said longitudinal coverings (34) are made of a transparent hard material, in particular polycarbonate, whereby said illuminating elements (25) can be protected from outside break attempts.

5. A tubular post (12) for a fence as set forth in Claim 4 wherein the post (12) further comprises a base (19) having a cavity (20) shaped and dimensioned to receive the base of said post (12) so as to support and keep the same integral.

6. A tubular post (12) for a fence as set forth in Claim 5 wherein the post (12) further comprises a cap (21) whose internal cavity is shaped and dimensioned to receive the top of said post (12) so as to support and keep the same integral.

7. A tubular post (12) for a fence as set forth in any of the preceding claims wherein the cross sectional view of the central portion (17) of the first part (13) is one of a semi-circle, ellipse, triangle, square, pentagon or hexagon shapes.

8. A tubular post (12) for a fence as set forth in Claim 7 wherein said first and second parts (13, 14) are made of extruded aluminum.

9. A tubular post (12) for a fence as set forth in Claim 8 wherein said base (19) has a plurality of mounting slots (22) in the shape that allow limited transitional movement of the post (12) for stretching the fence material.

10. A tubular post (12) for a fence as set forth in Claim 1 wherein said illuminating element (25) is powered by a solar energy source.

11. A fence comprising a plurality of posts as set forth in any of the preceding claims, and a bundle of fence material selected from one or more of the group consisting of mesh wires, welded wires, razor wires, gabion, single panels, double reinforced panels and framed panels.

## Patentansprüche

1. Pfosten (12) für einen Zaun, der ein hohles sich in Längsrichtung erstreckendes erstes Teil (13) mit Ohr-Abschnitten (15, 16) an beiden Seiten eines zentralen Abschnitts (17) aufweist, ein zweites Teil (14), das das erste Teil (13) in Längsrichtung teleskopartig verlängert, wobei das erste Teil (13) des Pfostens (12) ein oder mehrere Längsgehäuse (33) zur Aufnahme von Beleuchtungselementen (25) aufweist, wobei das/die in Längsrichtung angeordnete(n) Gehäuse (33) ein oder mehrere Beleuchtungselement(e) (25) umfasst/umfassen,
**dadurch gekennzeichnet, dass**
die Ohr-Abschnitte (15, 16) an deren äußeren Enden sich nach innen erstreckende Lippen (23, 24) mit einer Mehrzahl an sich in Längsrichtung erstreckenden seitlichen Öffnungen (18) aufweisen, die zum Aufnehmen von Enden des Zaunmaterials angepasst sind, wobei das erste Teil (13) des Pfostens (12) ein erstes in Längsrichtung hohles Innenprofil (31) mit geschlossener Geometrie aufweist, das durch mindestens zwei sich in Längsrichtung erstreckende Brückenelemente (32) mit einem zweiten sich in Längsrichtung erstreckenden Außenprofil (30) mit geschlossener Geometrie verbunden ist, das das erste Profil (31) umschließt, wobei das oder die Längsgehäuse (33) mit einem oder mehreren Beleuchtungselementen (25) durch Längsabdeckungen (34) verschlossen sind, welche ein erstes und ein zweites Ende besitzen, wobei jedes Ende in die offenendigen seitlichen Lippen (35) des/der Gehäuse(s) (33) passt/passen, indem die Abdeckung(en) (34) in das/die Gehäuse (33) eingeschoben wird/werden, so dass die längslaufende(n) Abdeckung(en) (34) über eine Schwalbenschwanzverbindung mit den offenen Enden der/des längslaufenden Gehäuse(s) (33) verbunden ist/sind, wobei die längslaufende(n) Abdeckung(en) (34) bündig mit der Außenoberfläche des Pfostens (12) abschließt/abschließen.

2. Rohrförmiger Pfosten (12) nach Anspruch 1 für einen Zaun, **dadurch gekennzeichnet, dass** die Brückenelemente (32), die sich zwischen dem Innenprofil 31 und dem Außenprofil 30 befinden, symmetrisch angeordnet sind.

3. Rohrförmiger Pfosten (12) nach Anspruch 2 für einen Zaun, **dadurch gekennzeichnet, dass** der größte Abstand zwischen zwei Umfangsstellen in einer horizontalen Ebene des Pfostens (12) senkrecht zur Zaunachse liegt.

4. Rohrförmiger Pfosten (12) nach Anspruch 1 für einen Zaun, **dadurch gekennzeichnet, dass** die längslaufenden Abdeckungen (34) aus einem transparenten harten Material bestehen, insbesondere Polycarbonat, wodurch die Beleuchtungselemente (25) vor Beschädigungen von außen geschützt sind.

5. Rohrförmiger Pfosten (12) nach Anspruch 1 für einen Zaun, **dadurch gekennzeichnet, dass** der Pfosten (12) zusätzlich einen Fuß (19) mit einem Hohlraum (20) aufweist, der derart geformt und dimensioniert ist, dass er den Fuß des Pfostens (12) aufnimmt, um den Fuß (19) und den Pfosten (12) integral zu stützen und zu halten.

6. Rohrförmiger Pfosten (12) nach Anspruch 5 für einen Zaun, **dadurch gekennzeichnet, dass** der Pfosten (12) zusätzlich eine Kappe (21) mit einem Hohlraum aufweist, der derart geformt und dimensioniert ist, dass er die Spitze des Pfostens (12) aufnimmt, um die Kappe (21) und den Pfosten (12) integral zu stützen und zu halten.

7. Rohrförmiger Pfosten (12) nach einem der vorherigen Ansprüche für einen Zaun, **dadurch gekennzeichnet, dass** der zentrale Abschnitt (17) des ersten Teils (13) eine halbkreisförmige, elliptische, dreieck-, viereck-, fünfeck- oder sechseckförmige Form aufweist.

8. Rohrförmiger Pfosten (12) nach Anspruch 7 für einen Zaun, **dadurch gekennzeichnet, dass** das erste Teil (13) und das zweite Teil (14) aus stranggepresstem Aluminium hergestellt sind.

9. Rohrförmiger Pfosten (12) nach Anspruch 8 für einen Zaun, **dadurch gekennzeichnet, dass** der Fuß (19) eine Mehrzahl von Befestigungsnuten (22) aufweist, die derart geformt sind, dass sie die Querbewegung des Pfostens (12) und das Dehnen des Zaunmaterials begrenzen.

10. Rohrförmiger Pfosten (12) nach Anspruch 1 für einen Zaun, **dadurch gekennzeichnet, dass** das Beleuchtungselement (25) von einer solaren Energiequelle betrieben wird.

11. Zaun mit einer Mehrzahl von Pfosten nach einem der vorherigen Ansprüche und einer Menge an Zaunmaterial, das eine Auswahl einer oder mehrerer Materialien der Gruppe bestehend aus Drahtgeflechten, geschweißten Drähten, Stacheldrähten, Gabionen, Einzelplatten, doppelt verstärkten Platten und gerahmten Platten ist.

## Revendications

1. Poteau de clôture (12) comportant une première partie creuse s'étendant longitudinalement (13) qui comporte des portions d'oreille (15, 16) des deux côtés d'une portion centrale (17), une seconde partie (14) qui s'étend longitudinalement dans ladite première partie (13) de manière télescopique, **caractérisé en ce que** :
ladite première partie (13) du poteau (12) comporte un ou plusieurs logements longitudinaux (33) destinés à recevoir des éléments d'éclairage (25), ledit ou lesdits logements longitudinaux (33) comportent un ou plusieurs éléments d'éclairage (25),
lesdites portions d'oreille (15, 16) ont, sur leurs extrémités extérieures, des lèvres s'étendant vers l'intérieur (23, 24) avec une pluralité d'ouvertures latérales s'étendant longitudinalement (18) adaptées pour recevoir des extrémités d'un matériel de clôture, ladite première partie (13) du poteau (12) est pourvue d'un premier profilé intérieur creux à géométrie fermée, s'étendant longitudinalement (31) interconnecté par au moins deux éléments formant un pont (32) s'étendant longitudinalement jusqu'à un second profilé extérieur à géométrie fermée, s'étendant longitudinalement (30) enfermant ledit premier profilé (31),
ledit ou lesdits logements longitudinaux (33) comportant un ou plusieurs éléments d'éclairage sont fermés par des éléments de recouvrement longitudinaux (34) ayant une première et une seconde extrémité, chaque extrémité s'insérant dans des lèvres latérales (35) d'extrémité ouverture dudit logement ou desdits logements (33) en faisant glisser lesdits éléments de recouvrement (34) à l'intérieur dudit ou desdits logements (33) de telle sorte que ledit ou lesdits éléments de recouvrement longitudinaux (34) sont configurés pour avoir une liaison en queue d'aronde avec l'extrémité ouverte dudit ou desdits logements longitudinaux (33), et
ledit ou lesdits éléments de recouvrement longitudinaux (34) affleurent la surface extérieure restante du poteau (12).

2. Poteau tubulaire (12) pour une clôture selon la revendication 1, dans lequel lesdits éléments formant un pont (32) parmi lesdits profilés (30, 31) sont agencés de manière symétrique.

3. Poteau tubulaire (12) pour une clôture selon la revendication 2, dans lequel la plus longue distance entre deux points circonférentiels sur un plan horizontal du poteau (12) est perpendiculaire à la ligne de clôture.

4. Poteau tubulaire (12) pour une clôture selon la revendication 1, dans lequel lesdits éléments de recouvrement longitudinaux (34) sont constitués d'un matériau dur transparent, en particulier de polycarbonate, en sorte que lesdits éléments d'éclairage (25) peuvent être protégés contre des tentatives de coupure extérieure.

5. Poteau tubulaire (12) pour une clôture selon la revendication 4, dans lequel le poteau (12) comporte en outre une base (19) ayant une cavité (20) formée et dimensionnée pour recevoir la base dudit poteau (12) de manière à supporter et maintenir celui-ci d'un seul tenant.

6. Poteau tubulaire (12) pour une clôture selon la revendication 5, dans lequel le poteau (12) comporte en outre une coiffe (21) dont la cavité interne est formée et dimensionnée pour recevoir le dessus dudit poteau (12) de manière à supporter et maintenir celui-ci d'un seul tenant.

7. Poteau tubulaire (12) pour une clôture selon l'une quelconque des revendications précédentes, dans lequel la vue en coupe transversale de la portion centrale (17) de la première partie (13) est une forme parmi un demi-cercle, une ellipse, un triangle, un carré, un pentagone ou un hexagone.

8. Poteau tubulaire (12) pour une clôture selon la revendication 7, dans lequel lesdites première et seconde parties (13, 14) sont en aluminium extrudé.

9. Poteau tubulaire (12) pour une clôture selon la revendication 8, dans lequel ladite base (19) a une pluralité de fentes de montage (22) dont la forme permet un mouvement de transition limité du poteau (12) pour tendre le matériel de clôture.

10. Poteau tubulaire (12) pour une clôture selon la revendication 1, dans lequel ledit élément d'éclairage (25) est alimenté par une source d'énergie solaire.

11. Clôture comportant une pluralité de poteaux selon l'une quelconque des revendications précédentes, et un paquet de matériel de clôture choisi parmi un ou plusieurs éléments du groupe constitué de fils en treillis, de fils soudés, de barbelés à lames, d'un gabion, de panneaux individuels, de doubles panneaux renforcés et de panneaux encadrés.
